# EUROPEAN PATENT APPLICATION

(11) **EP 1 624 735 A1**
(43) Date of publication of application: **08.02.2006**
(21) Application number: 05254816.1
(22) Date of filing: 01.08.2005
(51) Int. Cl.: H05K 1/02

(54) **Methods of forming devices having optical functionality**

(30) Priority: 03.08.2004 US 598729 P
(71) Applicant: Rohm and Haas Electronic Materials, L.L.C., Marlborough, Massachusetts 01752 (US)
(72) Inventor: Shelnut, James G., Lancaster, Massachusetts 01523 (US); Pugliano, Nicola, Grafton, Massachusetts 01519 (US); Moynihan, Matthew L., Sterling, Massachusetts 01564 (US); Sicard, Bruno M., Shrewsbury, Massachusetts 01545 (US)
(74) Representative: Kent, Venetia Katherine

(57) **Abstract**

Provided is a method of forming a device having optical functionality. The method includes forming an optical waveguide over a substrate by providing a clad layer and a core over the substrate. The clad layer includes a polymer having units of the formula (RSiO_{1.5}), wherein R is a substituted or unsubstituted organic group, and a photoactive component. A portion of the clad layer is photolithographically patterned. Also provided is a method of forming a printed wiring board having optical functionality. The invention has particular applicability in the electronics industry for forming optoelectronic devices.

## Description

### BACKGROUND OF THE INVENTION

The present invention relates generally to the field of optoelectronics. In particular, the present invention relates to methods of forming devices having optical functionality. Further, the invention relates to methods of forming printed wiring boards having optical functionality.

Signal transmission using pulse sequences of light is becoming increasingly important in high-speed communications. For example, optical integrated circuits (OICs) are gaining importance for high bandwidth optical interconnects. As a result, the integration of optical components such as waveguides, filters, optical interconnects, lenses, diffraction gratings, and the like, is becoming increasingly important.

Planar optical waveguides include a core and a clad surrounding the core, with optical radiation propagating in the core due to its higher index of refraction as compared to the clad. Embedded or planar optical waveguides may be formed on a substrate, for example, a printed wiring board such as a backplane or a semiconductor wafer, by coating a bottom clad layer on the substrate, coating a core layer on the bottom clad layer, patterning the core layer into one or more core structures, and forming a top clad layer over the bottom clad layer and core structures. The waveguide core layer is patterned, for example, using standard photolithography and etching processes with a patterned photoresist, or by exposing through a photomask and developing a photoimageable core layer.

Use of photolithographic techniques in waveguide formation has generally focused on the formation of the waveguide core structures. The ability to incorporate detailed structures in the waveguide clad by photolithographic techniques would also, however, be desirable. This would provide increased manufacturability options by allowing for the formation of structures in the clad, for example, for purposes of waveguide connectorization (e.g., to optical fibers), alignment accuracy, optoelectronic device placement, and out-of-plane light turning (e.g., optical via formation).

U.S. Patent No. 6,555,288 discloses planar waveguides made from fluorohydrocarbon monomers, oligomers, or polymer components end-capped with radiation curable ethylenically unsaturated groups, such as acrylate or methacrylate groups. In one embodiment, the '288 patent describes formation of a planar waveguide in which the upper cladding layer is patterned by exposure to actinic radiation through a photomask and development. A ridge-like structure in which the upper clad covers the top and sides of the core and which extends above the plane of the lower cladding and substrate is formed.

Various drawbacks are associated with the use of acrylates in forming optical components. For example, acrylates suffer from the disadvantage of being structurally and optically dissimilar to glass, which is the current material of choice for optical fibers and pigtail structures. Further, acrylates are known to absorb relatively high amounts of moisture, which may result in reliability problems. Moreover, acrylates are generally not suitable for use in high temperature applications. At temperatures approaching 200°C, most acrylate materials begin to decompose and depolymerize.
There is thus a need in the art for improved methods of forming devices which have optical functionality, which overcome or conspicuously ameliorate one or more of the foregoing problems associated with the state of the art.

### SUMMARY OF THE INVENTION

One aspect of the invention provides methods of forming a device having optical functionality. The methods involve forming an optical waveguide on a substrate by providing a clad layer and a core on the substrate. The clad layer includes a polymer having units of the formula (RSiO_{1.5}), wherein R is a substituted or unsubstituted organic group, and a photoactive component. A portion of the clad layer is photolithographically patterned.
In a second aspect of the invention, a method of forming a printed wiring board having optical functionality is provided. The method includes forming a first clad layer on a printed wiring board substrate, forming a core on the first clad layer, and forming a second clad layer on the first clad layer and core. The first clad layer and/or the second clad layer includes a polymer with units of the formulae (RSiO_{1.5}) and (R₁SiO_{1.5}), wherein R and R₁ are different and are chosen from substituted and unsubstituted organic groups, and a photoactive component. A portion of the first clad layer and/or the second clad layer is photolithographically patterned.

### BRIEF DESCRIPTION OF THE DRAWINGS

The present invention will be discussed with reference to the following drawings, in which like reference numerals denote like features, and in which:
FIG. 1A-F illustrates in cross-section an exemplary device having optical functionality at various stages of formation thereof, formed in accordance with the invention; and
FIG. 2 illustrates an exemplary electronic device having optical functionality, formed in accordance with the invention.

### DETAILED DESCRIPTION OF THE INVENTION

The present invention provides methods of forming devices having optical functionality. The devices include an optical waveguide which include clad and core structures. The clad is formed of one or more photoimageable layers in which patterns are created photolithographically. The clad includes a hybrid organic-inorganic polymer having units of the formula (RSiO_{1.5}), wherein R is a substituted or unsubstituted organic group, and a photoactive component.

Unless otherwise specified, amounts for components of the composition are given in weight percentage based on the composition absent any solvent. As used herein, the term "polymer" includes oligomers, dimers, trimers, tetramers and the like, and encompasses homopolymers and higher order polymers, i.e., polymers formed from two or more different monomer units and heteropolymers. The term "alkyl" refers to linear, branched and cycloalkyl groups, which are substituted or unsubstituted and may include heteroatoms in or on the chain. The term "aromatic" refers to aromatic groups, which are substituted or unsubstituted and may include heterocycles. The terms "halogen" and "halo" include fluorine, chlorine, bromine, and iodine. Thus the term "halogenated" refers to fluorinated, chlorinated, brominated, and iodinated. The terms "a" and "an" mean "one or more". The term "on" and "over" are used interchangeable in defining spatial relationships, and encompass the presence or absence of intervening layers or structures.

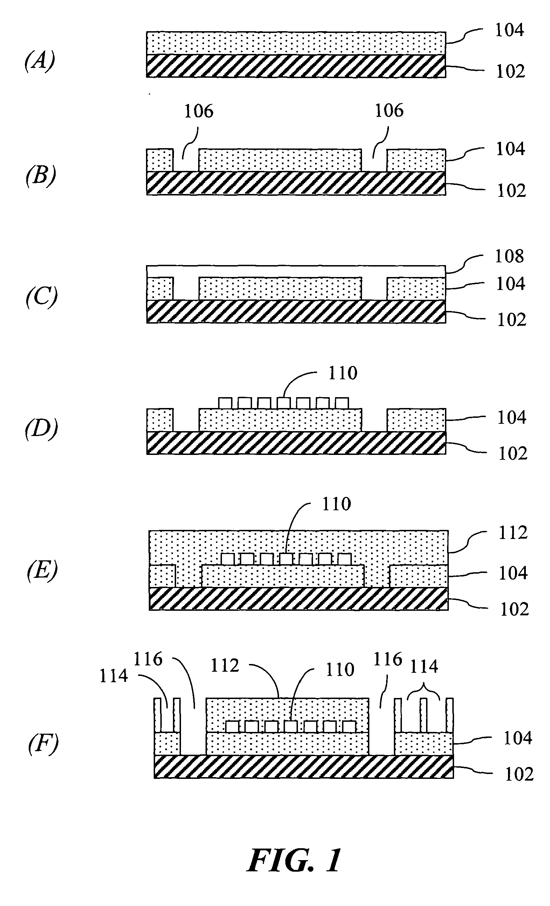

The present invention will now be described with reference to FIG. 1, which illustrates in cross-section a device having optical functionality at various stages of formation thereof in accordance with an exemplary aspect of the invention. As shown in FIG. 1A, a substrate 102 is provided. Typical substrates include those used in the manufacture of electronic devices such as printed wiring boards, integrated circuits and liquid crystal displays (LCDs). Exemplary such substrates include epoxy laminates, polyimide films, semiconductor wafers such as silicon, gallium arsenide, and indium phosphide wafers, and glass substrates. The substrates typically include one or more layers/structures thereon, for example, dielectric materials such as silicon oxides, silicon nitrides, and silicon oxynitrides, sapphires, epoxy laminates, polyimides, polysiloxanes, and metal materials such as copper, aluminum, and the like.

A bottom clad layer 104 is provided over the substrate 102. The bottom clad layer is formed from a composition that includes an polymer having units of the formula (RSiO_{1.5}), wherein R is a substituted or unsubstituted organic group. The polymer may have a plurality of functional end groups. The composition further includes a component for altering the solubility of the composition upon photoactivation.

The polymers useful in the present invention include, for example, silsesquioxanes, caged siloxanes and combinations thereof. The polymer may be present in the composition in an amount of from 1 to 99.5 wt%, for example from 60 to 98.5 wt%. Exemplary organic groups for R include substituted and unsubstituted alkyl, aryl and heterocyclic groups. The alkyl groups may be straight chain, branched or cyclic having, for example, from 1 to 20 carbon atoms, and typically have from 1 to 20 carbon atoms, such as methyl, ethyl, propyl, isopropyl, t-butyl, t-amyl, octyl, decyl, dodecyl, cetyl, stearyl, cyclohexyl, and 2-ethylhexyl. The alkyl groups may be substituted with heteroatoms in and/or on the alkyl chain, for example, or may be non-aromatic cyclic groups such as cyclopentyl, cyclohexyl, norbonyl, adamantly, piperidinyl, tetrahydrofuranyl and tetrahydrothiophenyl groups. Exemplary aryl groups include those having from 6 to 20 carbon atoms, for example, from 6 to 15 carbon atoms, such as phenyl, tolyl, benzyl, 1-naphthyl, 2-naphthyl and 2-phenanthryl, and may be substituted with heteroatoms, for example hydroxy and/or amino. Heterocyclic groups may be aromatic, for example, thiophene, pyridine, pyrimidine, pyrrole, phosphole, arsole, and furane.

Typical for R is a substituted and unsubstituted methyl, ethyl, propyl, cyclopentyl, cyclohexyl, benzyl, phenyl, adamantyl groups, and combinations thereof.

The polymer may take the form of a copolymer or higher order polymer, either random- or block-type. The polymer may include, for example, one or more additional silicon-containing units, with the proportions for each unit ranging from 1 to 85 wt%, for example, from 15 to 80 wt% or from 25 to 60 wt%, or from 25 to 50 wt%, based on the polymer. The additional units may, for example, be represented as silsesquioxanes, cage siloxanes, siloxanes and combinations thereof. For example, the polymer may further include units of the formula (R¹SiO_{1.5}), wherein R¹ is a substituted or unsubstituted organic group as described above with respect to R. One of R and R¹ may, for example, be chosen from substituted or unsubstituted alkyl groups, and the other of R and R¹ chosen from substituted or unsubstituted aryl groups. The polymer may be, for example, an alkyl silicon polymer such as a copolymer containing methyl silsesquioxane units and butyl silsesquioxane units; an aryl silicon polymer such as a copolymer containing phenyl silsesquioxane units and trifluoromethylphenyl-silsesquioxane units or an aralkyl silicon copolymer such as a copolymer containing methyl and phenyl silsesquioxane units.

Suitable siloxanes include, for example, units of the formula ((R²)₂SiO), wherein R² is a substituted or unsubstituted organic group, such as an alkyl group, for example, methyl, ethyl, propyl, and the like, or an aryl group, for example, phenyl, tolyl, and the like.

As described above, the side chain groups of the polymer may be optionally substituted. "Substituted" means that one or more hydrogen atoms on one or more side chain groups are replaced by another substituent group, for example, deuterium, halogen such as fluorine, bromine, and chlorine, (C₁-C₆)alkyl, (C₁-C₆)haloalkyl, (C₁-C₁₀)alkoxy, (C₁-C₁₀)alkylcarbonyl, (C₁-C₁₀)alkoxycarbonyl, (C₁-C₁₀)alkylcarbonyloxy, alkylamine, alkylsulfur containing materials, and the like. The polymers may contain a wide range of repeating units, either random or block. The polymer units useful in the present invention may have, for example, from 5 to 150 repeating units, typically from about 10 to 35 repeating units; and the siloxane units useful in the present invention may have for example from 5 to 150 repeating units, typically from about 7 to 25 repeating units. Thus, the polymer may vary widely in molecular weight. Typically, the polymers have a weight average molecular weight (M_{w}) of from about 500 to 15,000, more typically from about 1000 to 10,000, even more typically from about 1000 to 5000.

The polymers may include two or more functional end groups that allow a solubility change in the composition after photoactivation. Such end groups may be, for example, hydroxy; alkoxy such as ethoxy, propoxy, isopropoxy; carboxyester, amino, amido, epoxy, imino, carboxyacid, anhydride, olefinic, acrylic, acetal, orthoester, vinyl ether, and combinations thereof. The functional end content may be, for example, from about 0.5 to 35 wt% based on the polymer, for example from about 1 to 10 wt%, or from about 2 to 5 wt%.

The composition further includes a photoactive component. The photoactive component alters the solubility of the composition in a dried state in a developer. The photoactive component typically generates an acid or base upon activation. A wide variety of photoactive components may be used in the present invention, including, but not limited to, photoacid generators and photobase generators.

The photoacid generators useful in the present invention may be any compound or compounds which generate acid upon exposure to light. Suitable photoacid generators are known and include, but are not limited to, halogenated triazines, onium salts, sulfonated esters, substituted hydroxyimides, substituted hydroxylimines, azides, naphthoquinones such as diazonaphthoquinones, diazo compounds, and combinations thereof.

Particularly useful halogenated triazines include, for example, halogenated alkyl triazines such as the trihalomethyl-s-triazines. The s-triazine compounds are condensation reaction products of certain methyl-trihalomethyl-s-triazines and certain aldehydes or aldehyde derivatives. Such s-triazine compounds may be prepared according to the procedures disclosed in U.S. Pat. No. 3,954,475 and Wakabayashi et al., Bulletin of the Chemical Society of Japan, 42, 2924-30 (1969). Other triazine type photoacid generators useful in the present invention are disclosed, for example, in U.S. Patent. No. 5,366,846.

Onium salts with weakly nucleophilic anions are particularly suitable for use as photoacid generators in the present invention. Examples of such anions are the halogen complex anions of divalent to heptavalent metals or non-metals, for example, antimony, tin, iron, bismuth, aluminum, gallium, indium, titanium, zirconium, scandium, chromium, hafnium, copper, boron, phosphorus and arsenic. Examples of suitable onium salts include, but are not limited to, diazonium salts such as diaryl-diazonium salts and onium salts of group VA and B, IIA and B and I of the Periodic Table, for example, halonium salts such as iodonium salts, quaternary ammonium, phosphonium and arsonium salts, sulfonium salts such as aromatic sulfonium salts, sulfoxonium salts or selenium salts. Examples of suitable onium salts are disclosed, for example, in U.S. Patent Nos. 4,442,197; 4,603,101; and 4,624,912. Sulfonium salts such as triphenylsulfonium hexafluorophosphate and mixtures thereof are typical.

The sulfonated esters useful as photoacid generators in the present invention include, for example, sulfonyloxy ketones. Suitable sulfonated esters include, but are not limited to, benzoin tosylate, t-butylphenyl alpha-(p-toluenesulfonyloxy)-acetate, 2,6-dinitrobenzyl tosylate, and t-butyl alpha-(p-toluenesulfonyloxy)-acetate. Such sulfonated esters are disclosed, for example, in the Journal of Photopolymer Science and Technology, vol. 4, No. 3,337-340 (1991).

Substituted hydroxyimides which may be used include, for example, n-trifluoromethylsulfonyloxy-2,3-diphenylmaleimide and 2-trifluoromethylbenzenesulfonyloxy-2,3-diphenylmaleimide. Suitable substituted hydroxylimines include, for example, 2-(-nitrilo-2-methylbenzylidene)-(5-hydroxyiminobutylsulfonyl)-thiophene. Azides useful in the present invention include, for example, 2,6-(4-azidobenzylidene)cyclohexanone. Naphthoquinones may include, for example, 2,1-diazonaphthoquinone-4-sulfonate ester of 2,3,4-trihydroxybenzophenone. Among the diazo compounds, 1,7-bis(4-chlorosulonyl phenyl)-4-diazo-3,5-heptanedione may be used.

Photobase generators useful in the present invention may be any compound or compounds which liberate base upon exposure to light. Suitable photobase generators include, but are not limited to, benzyl carbamates, benzoin carbamates, O-carbamoylhydroxyamines, O-carbamoyloximes, aromatic sulfonamides, alpha-lactams, N-(2-allylethenyl)amides, arylazide compounds, N-arylformamides, 4-(ortho-nitrophenyl)dihydropyridines, and combinations thereof.

The amount of the photoactive component for altering the solubility useful in the present invention, in the case of a negative working material, is any amount sufficient to alter the solubility of the composition upon exposure to actinic radiation and render the exposed portion insoluble in a developer. The photoactive component is typically present in the composition in an amount of from 0.1 to 25 wt%, for example from 0.1 to 12 wt%.

One or more components for improving the flexibility of the structures formed from the composition may be present in the composition. These flexibility-improving materials typically contain a plurality of functional groups chosen from hydroxy, amino, thiol, sulphonate ester, carboxylate ester, silyl ester, anhydride, aziridine, methylolmethyl, silyl ether, epoxides, oxetanes, vinyl ethers, silanols and combinations thereof. In the flexibility-improving materials, the functional groups are typically attached to backbone materials. Exemplary backbone materials include substituted and unsubstituted alkyl and aryl hydrocarbons, ethers, acrylates, novolacs, polyimides, polyurethanes, polyesters, polysulfones, polyketones, fullerenes, POSS silicons, nanoparticles, and combinations thereof. The functional groups may be present as end groups on the backbone and/or at one or more locations along the backbone.

Examples of flexibilizing components are polyols of formula R³(OH)ₓ wherein R³ is an organic group chosen from substituted or unsubstituted (C₂-C₂₅) alkyl, (C₇-C₂₅) aryl, (C₈-C₂₅) aralkyl, (C₆-C₂₅) cycloalkyl, and combinations thereof, wherein x is 2 or more and does not exceed the number of carbon atoms. When x is 2, examples of the flexibilizing component include glycols, which are 1,2 diols, such as HOCH₂-CHOH-(CH₂)_{y}-CH₃ wherein y may be, for example, from 0 to 22, such as propylene glycol and butylene glycol. Other examples include α,ω-diols such as HO-(CH₂)_{z}-OH wherein z is, for example, from 2 to 25 such as ethylene glycol, 1,3-propanediol and 1,4-butanediol. When x is 3 examples include glycerin and trimethylolpropane.

R³ may also be a polyether of formula -O-(CR⁴₂)_{w}- wherein w is, for example, from 1 to 13 and R⁴ is the same or different and may be, for example, H, or a substituted or unsubstituted organic group of formula C₁-C₁₂ alkyl, aryl, aralkyl or cycloalkyl. Examples of flexibilizing components include polyether diols of polyethylene oxide, polypropylene oxide, polybutylene oxide, and polytetrahydrofurane.

The flexibility-improving component may have a weight average molecular weight, for example, of from 62 to 5000, for example from 62 to 2000. This component is present in an effective amount to improve the flexibility of the composition in a dried state before and after activation. The specific amount will depend, for example on the backbone and type of and number of functional groups of the flexibility-improving component. This component may, for example, be present in the composition in an amount of from 0.5 to 35wt%, for example from 2 to 20 wt%.

In addition to the foregoing flexibilizers, the use of siloxanes such as those described above with reference to the polymer having units of the formula ((R²)₂SiO) may be used.

Other additives may optionally be present in the compositions of the invention including, but are not limited to, surface leveling agents, wetting agents, antifoam agents, adhesion promoters, thixotropic agents, fillers, viscosity modifiers, and the like. Such additives are well known in the art of coating compositions. The use of surface leveling agents, for example silicone-base oils such as SIL WET L-7604 silicone-base oil available from Dow Chemical Company, in the compositions may be used. It will be appreciated that more than one additive may be combined in the compositions of the present invention. For example, a wetting agent may be combined with a thixotropic agent. The amounts of such optional additives to be used in the present compositions will depend on the particular additive and desired effect, and are within the ability of those skilled in the art. Such other additives are typically present in the composition in an amount of less than 5 wt%, for example less than 2.5 wt%.

The compositions useful in the methods of the invention may optionally contain one or more organic cross-linking agents. Cross-linking agents include, for example, materials which link up components of the composition in a three-dimensional manner. Aromatic or aliphatic cross-linking agents that react with the silicon-containing polymer are suitable for use in the present invention. Such organic cross-linking agents will cure to form a polymerized network with the silicon-containing polymer, and reduce solubility in a developer solution. Such organic cross-linking agents may be monomers or polymers. It will be appreciated by those skilled in the art that combinations of cross-linking agents may be used successfully in the present invention.

Suitable organic cross-linking agents useful in the present invention include, but are not limited to, amine containing compounds, epoxy containing materials, compounds containing at least two vinyl ether groups, allyl substituted aromatic compounds, and combinations thereof. Typical cross-linking agents include amine containing compounds and epoxy containing materials.

The amine containing compounds useful as cross-linking agents in the present invention include, but are not limited to, melamine monomers, melamine polymers, alkylolmethyl melamines, benzoguanamine resins, benzoguanamine-formaldehyde resins, urea-formaldehyde resins, glycoluril-formaldehyde resins, and combinations thereof.

It will be appreciated by those skilled in the art that suitable organic cross-linker concentrations will vary with factors such as cross-linker reactivity and specific application of the composition. When used, the cross-linking agent(s) is typically present in the composition in an amount of from 0.1 to 50 wt%, for example, from 0.5 to 25 wt% or from 1 to 20 wt%.

The compositions may optionally contain one or more solvents. Such solvents aid in formulating the compositions and in coating the compositions on a substrate. A wide variety of solvents may be used. Suitable solvents include, but are not limited to, glycol ethers, such as ethylene glycol monomethyl ether, propylene glycol monomethyl ether, and dipropylene glycol monomethyl ether, esters such as methyl cellosolve acetate, ethyl cellosolve acetate, propylene glycol monomethyl ether acetate, dipropylene glycol monomethyl ether acetate, dibasic esters, carbonates such as propylene carbonate, γ-butyrolactone, esters such as ethyl lactate, n-amyl acetate and n-butyl acetate, alcohols such as n-propanol, iso-propanol, ketones such as cyclohexanone, methyl isobutyl ketone, diisobutyl ketone and 2-heptanone, lactones such as γ-butyrolactone and γ-caprolactone, ethers such as diphenyl ether and anisole, hydrocarbons such as mesitylene, toluene and xylene, and heterocyclic compounds such as N-methyl-2-pyrrolidone, N,N'-dimethylpropyleneurea, or mixtures thereof.

The compositions may be prepared by combining, in admixture, the silicon-containing polymer, the catalytic component, and other optional components in any order.

The bottom clad layer 104 (as well as the other waveguide layers to be described) may be formed by any technique including, but not limited to, screen printing, curtain coating, roller coating, slot coating, spin coating, flood coating, electrostatic spray, spray coating, or dip coating. When the bottom clad layer is formed by spray coating, a heated spray gun may optionally be used. The viscosity of the composition may be adjusted to meet the requirements for each method of application by viscosity modifiers, thixotropic agents, fillers and the like.

The coated substrate may then be dried using heat to substantially remove from the layer any solvent in the composition. Such drying may take place at various temperatures, depending upon the particular solvent chosen. Typical drying may be at any temperature from 20 to 300°C, for example from 30°C to 200°C. Such drying may occur, for example, over a period of from 5 seconds to 60 minutes in an oven or on a hot plate. The bottom cladding layer 104 is typically deposited to a thickness in the dried state of from about 1 to 100 µm, for example, from about 10 to 50 µm.

With reference to FIG. 1B, the bottom clad layer 104 is next photolithographically processed to form one or more patterns 106 therein. The bottom clad layer 104 is typically exposed to actinic radiation through a photomask that contains a desired pattern, with the pattern being transferred to the bottom clad layer. Typical photomasks include, for example, a chromium pattern on glass, a silver pattern on polyethylene or a diazo pattern on polyester. The radiation is typically from 10 to 2000 mJ/cm², for example from 50 to 1000 mJ/cm². The exposure wavelength is typically from 290 to 450 nm, for example from 300 to 400 nm. Maskless exposure techniques may alternatively be used. Suitable exposure methods include, for example, contact imaging, projection imaging, and laser direct write imaging, including laser direct write imaging by multiphoton absorption.

After exposure, the bottom clad layer 104 is exposed to a developing solution in which portions of the layer are removed. In the case of a negative acting material, the unexposed areas of the layer are removed. The developer may be an aqueous or non-aqueous developer solution, or a combination thereof, and may optionally include one or more additives, for example, antifoaming agents, surfactants and the like. Typical aqueous developers include, for example, alkali metal hydroxides such as sodium hydroxide and potassium hydroxide in water, as well as tetraalkylammonium hydroxide such as tetramethylammonium hydroxide, in water. Such developers are typically used in concentrations from 0.1 to 2N, for example, 0.15 to 1N, or 0.26 to 0.7N.

Typical non-aqueous developers include, for example, ketones, for example acetone, methyl ethyl ketone, methyl isobutyl ketone, cyclohexanone, 2-octanone, 2-heptanone and methyl isoamyl ketone; alcohols such as ethanol, isopropanol, n-propanol, n-butanol, isobutanol and benzyl alcohol; esters such as ethyl acetate, ethyl propionate and ethyl lactate; glycol ethers such as ethylene glycol methyl ether, propylene glycol ethyl ether, propylene glycol methyl ether; glycol ether esters such as ethylene glycol monomethyl ether acetate and propylene glycol mono methyl ether acetate; aromatics such as toluene, xylene, chlorobenzene, dichlorobenzene and the like, and combinations thereof.

Development is typically conducted at a temperature of from 20 to 85°C, for example from 21 to 49°C. Development time with aggressive agitation may be within ten minutes, for example, within five minutes, within two minutes, within one minute, or within 30 seconds. Development may take place, for example, in a static development chamber or in a spray chamber. Typical spray pressures range from 5 to 40 psi, for example, from 10 to 25 psi.

Following development, the bottom clad layer 104 may undergo a final cure step. The curing may, for example, include a flood exposure, for example, with 1 to 2 Joules/cm² of actinic radiation. Additionally or alternatively, the waveguides may be heated, for example, at a temperature of from about 130° to 300° C in air or an inert atmosphere such as nitrogen or argon.

As illustrated in FIG. 1C, a core layer 108 is next formed over the bottom clad layer 104 and exposed portions of the substrate 102, and is processed to form waveguide cores 110, as shown in FIG. 1D. The core material is selected such that the resulting cores have a higher refractive index than the bottom core layer 104. The composition making up the core layer 108 may be photoimageable or non-photoimageable, and may be chosen from the materials described above for the bottom clad layer 104 or other known materials. Thus, the cores 110 may be generated photolithographically as illustrated. Alternatively the cores may be formed by altering the refractive index, for example, by exposing the core layer 108 to actinic radiation in a direct imaging process, without the need to physically remove material from the core layer.

A top clad layer 112 is next formed over the bottom clad layer 104 and cores 110, as shown in Fig 1E. In the exemplified method, top clad layer 112 is photoimageable. The same materials described above with reference to the bottom clad layer 104 may be used for the top clad layer 112. The refractive index of the top clad layer is less than that of the core structures 110, and is typically the same or substantially the same as the bottom clad. The top clad layer 112 is photolithographically processed in the same manner described above with respect to the bottom clad layer 104, and patterns 114, 116 are thus formed, as illustrated in FIG IF.

The methods in accordance with the invention allow for one or both of the clad layers 104, 112 to be photolithographically processed to fabricate patterns in the clad layers. If the bottom or top clad layer is not to be photolithographically patterned, that layer may be photocured by exposing the entire surface to actinic radiation where a photosensitive composition is used. A thermally active component such as a thermal acid or base generator may be substituted for the photoactive component, in which case the layer may be thermally cured.

The methods of the invention allow for patterns to be fabricated in the one or more layers which form the waveguide clad. These patterns may be used, for example, for purposes of waveguide connectorization (e.g., to optical fibers), alignment accuracy (e.g., alignment fiducials), electronic device placement (e.g., device recesses), and out-of-plane light turning (e.g., optical vias). It may be appreciated by those skilled in the art that patterns in the clad have many useful purposes.

The present methods are particularly suitable for use in the manufacture of electronic devices such as printed wiring boards and integrated circuits that include optical functionality in the form of an optical waveguide.

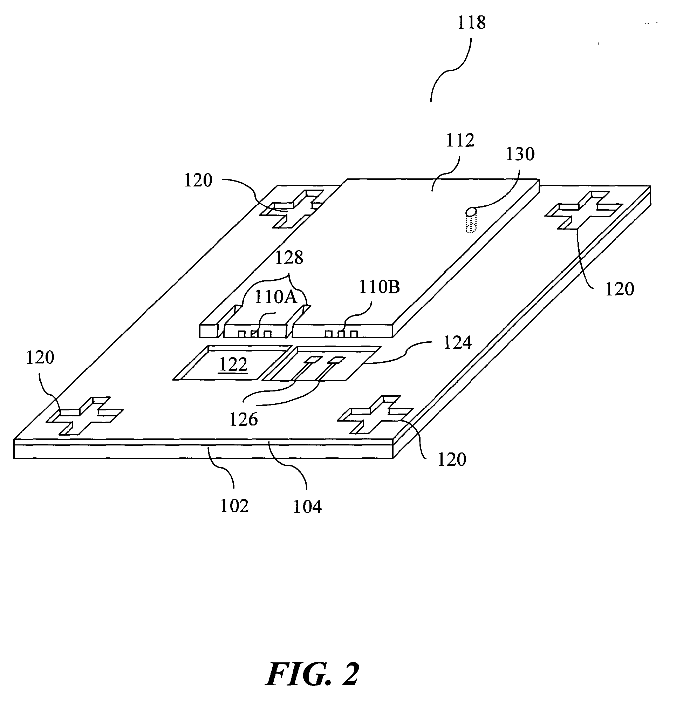

FIG. 2 illustrates an exemplary electronic device 118 formed by photolithographically patterning a clad layer in accordance with the invention. The methods and materials described above with reference to FIG. 1 are applicable unless otherwise stated. The electronic device 118 may be, for example, a printed wiring board, a semiconductor device such as an integrated circuit or a liquid crystal display. The device 118 includes an electronic device substrate 102 such as described above, for example, a printed wiring board substrate, a semiconductor wafer, or a liquid crystal display substrate. A bottom clad layer 104 is formed on the surface of the substrate 102, and one or more patterns may be formed therein. In the device shown, the bottom clad layer 104 is imaged by exposure to actinic radiation and development, and alignment patterns (alignment fiducials) 120, connectorization recess 122 and electronic device recess 124 may be formed in the bottom clad layer. The alignment patterns 120 allow for accurate alignment during subsequent processing, for example, alignment of a photomask to the substrate during subsequent photolithographic processing or of a laser during laser ablation. The connectorization recess 122 in the bottom clad layer may, for example, provide a recess for placement of a connector (not shown) which connects components such as optical signal carriers (e.g., optical fibers) with embedded waveguides such as those including cores 110A. The device recess 124 exposes a previously formed metallization structure which may include electrical leads and bonding pads 126 for electrically connecting one or more electronic devices (not shown). The electronic device may be, for example, an optoelectronic device such as a laser or a photodetector.

Core structures 110A and 110B are formed on the bottom clad layer 102 as described above. A top clad layer 112 is next formed over a portion of the bottom clad layer 104 and the core structures 110A, 110B. One or more patterns may be formed in the top clad layer. In the exemplified device, the top clad layer 112 is imaged by exposure to actinic radiation and development. Structures such as connectorization slots 128 and optical vias 130 may be formed therein. The connectorization slots 128 may be matched for mating engagement with a connector, such as a connector containing one or more optical fibers for connection to embedded waveguides 110A. The slot geometry is merely exemplary, and other shapes are envisioned. The connectorization slots 128 and connectorization recess 122 may be provided for securing a connector. Optical via 130 may be formed to be in optical communication with one or more core structures 110B, and provides an out-of-plane light path to or from the waveguides. While particular clad patterns have been illustrated, such structures are merely exemplary and other structures are also envisioned.

The following prophetic examples are intended to illustrate further exemplary aspects of the present invention, but are not intended to limit the scope of the invention in any aspect. The weight percentages given are based on full compositions including solvent.

### EXAMPLE 1

### Bottom clad layer (photopatterned)

45.00 wt% propylene glycol monomethyl ether acetate, 54.84 wt% phenyl-methyl-dimethylsilsesquioxane (42.5:42.5:15 wt% based on polymer), 0.15 wt% triphenylsulfonium tosylate, and 0.01 wt% Dow SIL WET L-7604 silicone-base oil are combined in admixture. The composition is spin-coated at 2000 rpm on a six-inch silicon dioxide-coated silicon wafer and soft-baked in air on a hot plate for two minutes at 90°C, to a thickness of 8 µm. Artwork is placed directly on the composition. The artwork includes patterns for forming alignment fiducials of various dimensions and shapes, such as crossed lines, concentric circles and 90° angles. 800 mJ/cm² of actinic radiation is applied to the construction followed by a post-exposure-bake in air at 90°C for two minutes. The exposed wafer is dipped in a 0.7N sodium hydroxide developer solution held at 37.8°C (100°F) for 30 seconds. The wafer is rinsed in de-ionized water and dried. The wafer is heated to 200°C for 10 minutes. A bottom clad layer patterned with alignment fiducials is thereby formed

### Core structures

45 wt% propylene glycol monomethyl ether acetate, 40 wt% phenyl-methylsilsesquioxane (50:50 wt% based on polymer), 10 wt% polytetrahydrofurane, 4.99 wt% triphenylsulfonium tosylate, and 0.01 wt% Dow SIL WET L-7604 silicone-base oil are combined in admixture. The composition is spin-coated at 2000 rpm on the clad-coated and patterned wafer and is soft-baked in air on a hot plate for two minutes at 90°C, to a thickness of 8 µm. Artwork is placed directly on the composition. The artwork includes patterns for forming cores of various dimensions and shapes, such as linear, branched, and curved shaped cores between 2 and 14 cm in length and 5 to 15 µm in width. 800 mJ/cm² of actinic radiation is applied to the construction followed by a post-exposure-bake in air at 90°C for two minutes. The exposed wafer is dipped in a 0.7N sodium hydroxide developer solution held at 37.8°C (100°F) for 30 seconds. The wafer is rinsed in de-ionized water and dried. The wafer is heated to 200°C for 10 minutes. Core structures are thus fabricated on the patterned bottom clad layer.

### Top clad layer (photopatterned)

The same materials and procedures used in forming the bottom clad layer are used for a top clad layer, except the pattern on the artwork is different. The artwork contains slots of varying dimension from 50 to 1250 µm wide and from 0.5 to 3 cm long. A device including optical waveguides, alignment fiducials in the bottom clad layer and slots in the top clad layer is thereby formed.

### EXAMPLE 2

### Bottom clad layer

35.00 wt% propylene glycol monomethyl ether acetate, 59.99wt% phenyl-methyl silsesquioxane (33:67wt% based on polymer), 5 wt% dihydroxy-terminated polyethylene oxide, and 0.01 wt% Dow SIL WET L-7604 silicone-base oil are combined in admixture. The composition is spin-coated at 1200 rpm on a six-inch silicon dioxide-coated silicon wafer and soft-baked in air on a hot plate for two minutes at 90°C, to a thickness of 11.5 µm. The wafer is final cured at 200°C for 10 minutes in air on a hot plate. A bottom clad layer is thereby formed

### Core structures

35.00 wt% propylene glycol monomethyl ether acetate, 54.79 wt% phenyl-methylsilsesquioxane (50:50 wt% based on polymer), 10 wt% polydiphenylsiloxane, 0.20 wt% triphenylsulfonium tosylate, and 0.01 wt% Dow SIL WET L-7604 silicone-base oil are combined in admixture. The composition is spin-coated at 3000 rpm on the clad-coated wafer and soft-baked in air on a hot plate for two minutes at 110°C, to a thickness of 8 µm. Artwork is placed directly on the composition. The artwork includes patterns for forming cores of various dimensions and shapes, such as linear, branched, and curved shaped cores between 2 and 14 cm in length and 5 to 15 µm in width. 43 mJ/cm² of actinic radiation is applied to the construction followed by a post-exposure-bake in air at 90°C for 30 seconds. The exposed wafer is dipped in a 0.7N sodium hydroxide developer solution held at 37.8°C (100°F) for 2 minutes. The wafer is rinsed in de-ionized water and dried. The wafer is heated to 200°C for 10 minutes. Core structures are thus fabricated on the bottom clad layer.

### Top clad layer (photopatterned)

35.00 wt% propylene glycol monomethyl ether acetate, 57.99wt% phenyl-methyl silsesquioxane (33:67wt% based on polymer), 5 wt% dihydroxy-terminated polyethylene oxide, 0.2 wt% triphenylsulfonium perfluorobutanesulfonate and 0.01 wt% Dow SIL WET L-7604 silicone-base oil are combined in admixture. The composition is spin-coated at 1000 rpm on the wafer containing the bottom clad and core structures and soft-baked in air on a hot plate for two minutes at 90°C, to a thickness of 16 µm. Artwork is placed directly on the composition. The artwork includes patterns for forming slots of various dimensions from 50 to 1250 µm wide and from 0.5 to 3 cm long. 300 mJ/cm² of actinic radiation is applied to the construction followed by a post-exposure-bake in air at 90°C for 30 seconds. The exposed wafer is dipped in a 0.7N sodium hydroxide developer solution held at 37.8°C (100°F) for 2 minutes. The wafer is rinsed in de-ionized water and dried. The wafer is final cured at 200°C for 10 minutes in air on a hot plate. A device including optical waveguides and slots in the top clad layer is thereby formed.

### EXAMPLE 3

### Bottom clad layer (photopatterned)

45.00 wt% propylene glycol monomethyl ether acetate, 50.84 wt% phenyl-methyl-dimethylsilsesquioxane (32.5:52.5:15 wt% based on polymer), 0.15 wt% triphenylsulfonium tosylate, 4.00w wt% of polytetramethylene oxide (MW 1000) and 0.01 wt% Dow S_{IL WET} L-7604 silicone-base oil are combined in admixture. The composition is spin-coated at 2000 rpm on a six-inch silicon dioxide-coated silicon wafer and soft-baked in air on a hot plate for two minutes at 90°C, to a thickness of 8 µm. Artwork is placed directly on the composition. The artwork includes patterns for forming fiducials of various dimensions and shapes, such as crossed lines, concentric circles and 90° angles. 500 mJ/cm² of actinic radiation is applied to the construction followed by a post-exposure-bake in air at 90°C for two minutes. The exposed wafer is dipped in a 0.7N sodium hydroxide developer solution held at 37.8°C (100°F) for 30 seconds. The wafer is rinsed in de-ionized water and dried. The wafer is heated to 200°C for 10 minutes. A bottom core layer patterned with alignment fiducials is thereby formed.

### Core structures

35.00 wt% propylene glycol monomethyl ether acetate, 54.79 wt% phenyl-methylsilsesquioxane (50:50 wt% based on polymer), 10 wt% polydiphenylsiloxane, 0.20 wt% triphenylsulfonium tosylate, and 0.01 wt% Dow SIL WET L-7604 silicone-base oil are combined in admixture. The composition is spin-coated at 3000 rpm on the clad-coated and patterned silicon wafer and soft-baked in air on a hot plate for two minutes at 110°C, to a thickness of 8 µm. Artwork is placed directly on the composition. The artwork includes patterns for forming core structures of various dimensions and shapes, such as linear, branched, and curved shaped core structures between 2 and 14 cm in length and 5 to 15 µm in width. 43 mJ/cm² of actinic radiation is applied to the construction followed by a post-exposure-bake in air at 90°C for 30 seconds. The exposed wafer is dipped in a 0.7N sodium hydroxide developer solution held at 37.8°C (100°F) for 2 minutes. The wafer is rinsed in de-ionized water and dried. The wafer is heated to 200°C for 10 minutes. Core structures are thus fabricated on the bottom clad layer.

### Top clad layer

45.00 wt% propylene glycol monomethyl ether acetate, 50.99 wt% phenyl-methyl-dimethylsilsesquioxane (32.5:52.5:15 wt% based on polymer), 4.00 wt% polytetramethylene oxide (MW 1000) and 0.01 wt% Dow SIL WET L-7604 silicone-base oil are combined in admixture. The composition is spin-coated at 1000 rpm on the bottom clad and cores on the wafer and soft-baked in air on a hot plate for two minutes at 90°C, to a thickness of 12 µm. The wafer is heated to 200°C for 10 minutes. A device including optical waveguides and alignment fiducials in the bottom clad layer is thereby formed.

## Claims

1. A method of forming a device having optical functionality, comprising:
forming an optical waveguide on a substrate, comprising providing a clad layer and a core over the substrate, wherein the clad layer comprises a polymer comprising units of the formula (RSiO_{1.5}), wherein R is a substituted or unsubstituted organic group, and a photoactive component; and
photolithographically patterning a portion of the clad layer.

2. The method according to claim 1, wherein the forming an optical waveguide comprises:
forming a first clad layer over the substrate;
forming the core over the first clad layer; and
forming a second clad layer over the first clad layer and core;
wherein the first clad layer and/or the second clad layer comprises the polymer, and the photolithographic patterning comprises photolithographically patterning a portion of the first clad layer and/or the second clad layer.

3. The method according to claim 1 or 2, wherein the polymer further comprises units of the formula (R¹SiO_{1.5}), wherein R' is a substituted or unsubstituted organic group, and is different from R.

4. The method according to any of claims 1-3, wherein the polymer further comprises a unit of the formula ((R²)₂SiO), wherein R² is a substituted or unsubstituted organic group.

5. The method according to any of claims 1-4, wherein the photolithographic patterning comprises exposure of the first core layer and/or the second clad layer to actinic radiation and development with an aqueous developer solution.

6. The method according to any of claims 1-5, wherein the substrate is a printed wiring board substrate.

7. The method according to any of claims 1-6, wherein the photolithographic patterning comprises forming an opening in the first clad layer and/or the second clad layer, wherein the opening forms an optical via or a structure for connectorization.

8. The method according to any of claims 1-6, wherein the photolithographic patterning comprises forming an opening in the first clad layer and the second clad layer adjacent the waveguide to expose an underlying surface, the method further comprising bonding an optical or optoelectronic device to the surface, wherein the optical or optoelectronic device is in optical communication with the waveguide.

9. The method according to any of claims 1-6, wherein the photolithographic patterning forms an alignment pattern in the first clad layer and/or the second clad layer, the method further comprising using the alignment pattern for alignment purposes.

10. A method of forming a printed wiring board having optical functionality, comprising:
forming a first clad layer over a printed wiring board substrate;
forming a core over the first clad layer;
forming a second clad layer over the first clad layer and core;
wherein the first clad layer and/or the second clad layer comprises a polymer comprising units of the formulae (RSiO_{1.5}) and (R₁SiO_{1.5}), wherein R and R₁ are different and are chosen from substituted and unsubstituted organic groups, and a photoactive component; and
photolithographically patterning a portion of the first clad layer and/or the second clad layer.
